# EUROPEAN PATENT SPECIFICATION

(11) **EP 3 560 858 B1**
(45) Date of publication and mention of the grant of the patent: **08.12.2021**
(21) Application number: 17889480.4
(22) Date of filing: 17.04.2017
(51) Int. Cl.: B65D 90/00, B65D 88/12, H02S 30/20

(54) **PHOTOVOLTAIC CONTAINER**
FOTOVOLTAISCHER BEHÄLTER
RÉCIPIENT PHOTOVOLTAÏQUE

(30) Priority: 26.12.2016 CN 201611218651
(43) Date of publication of application: 30.10.2019
(73) Proprietor: Gree Electric Appliances, Inc. of Zhuhai, Zhuhai, Guangdong 519070 (CN)
(72) Inventor: WANG, Jian, Zhuhai Guangdong 519070 (CN); LIANG, Rongxin, Zhuhai Guangdong 519070 (CN); JIANG, Jinyuan, Zhuhai Guangdong 519070 (CN); TANG, Wenqiang, Zhuhai Guangdong 519070 (CN); FANG, Congcong, Zhuhai Guangdong 519070 (CN)
(74) Representative: Balder IP Law, S.L.
(86) International application number: PCT/CN2017/080695
(87) International publication number: WO 2018/120520

(56) References cited:
- WO-A1-2015/164913
- CN-U- 202 954 588
- CN-U- 204 957 317
- CN-U- 205 060 248
- DE-A1-102011 120 705
- DE-U1-202012 100 567
- GB-A- 2 463 098
- JP-A- 2006 041 350

## Description

### TECHNICAL FIELD

The present disclosure relates to a container, and more particularly, to a photovoltaic container.

### BACKGROUND

The photovoltaic container generates electricity by means of photovoltaic panels laid on the top surface of the container, and is able to form an independent power supply and utilization system. In recent years, the photovoltaic container is widely used in places where it is difficult to popularize the power facilities such as heath, island and so on, and is especially respected by the military and the fieldworkers working in the severe environment.

However, due to a relatively thin iron sheet of the top layer of the container, if the photovoltaic assembly is directly laid on the top surface of the container, the pressure of the weight of the photovoltaic assembly may easily cause depression and deformation of the iron sheet in the top layer of the container, which goes against the service life of the container. In addition, uneven top surface of the container is difficult to satisfy the technical requirements of laying the photovoltaic assembly; and when directly laying the photovoltaic assembly on the top surface of the container, too many installation procedures and aloft work may increase construction difficulty for the installers.

The document WO 2015/164913A1 discloses a portable power station designed as a 100% portable complete system configured to provide power, contained within a standard length shipping container. The portable power station comprises a housing having a base wall, side walls, end walls and a top wall. The housing is a standard size shipping container having container corners. The portable power station comprises a solar array which comprises four generally horizontal panel structures. The panel structures are movable between a stowed position within the upper internal space and an extended position. In this position, the panel structures are arranged in a stacked manner under the top wall and can be enclosed within the housing via the upper sections. In the extended position, each panel structure extends outwardly out of the housing, in a respective lateral direction.

### SUMMARY

In view of this, the present disclosure provides a photovoltaic container, and the main objective is to solve the technical problem that when the existing photovoltaic assembly is directly laid on the top surface of the container, the pressure of the weight of the photovoltaic assembly may easily cause depression and deformation of the iron sheet in the top layer of the container.

The above-mentioned objective is accomplished with the following technical solutions.

The present invention provides a photovoltaic container according to claim 1. Further details are given by the dependent claims.

The objective of the present disclosure and the technical measure for solving the technical problem thereof can be further implemented as follows.

In the above-mentioned photovoltaic container, the photovoltaic assembly is located above a top surface of the container body;
the photovoltaic assembly is mounted on the support fame which is mounted on a first part of the container body framework, the first part is located on a top of the container body.

In the above-mentioned photovoltaic container, optionally, the photovoltaic container has at least two layers of photovoltaic assemblies in a vertical direction;
wherein, each layer of photovoltaic assemblies is moveable relative to one another, to move to a first relative position at which the layers of photovoltaic assemblies overlap each other in the vertical direction and a second relative position at which the layers of photovoltaic assemblies are spread out relatively.

In the above-mentioned photovoltaic container, optionally, the layers of photovoltaic assemblies have a first layer of photovoltaic assemblies and a second layer of photovoltaic assemblies which are adjacently disposed;
the first layer of photovoltaic assemblies is fixed on the support frame;
the second layer of photovoltaic assemblies is movably disposed on the support frame, to move to the first relative position and the second relative position with respect to the first layer of photovoltaic assemblies.

In the above-mentioned photovoltaic container, optionally, the second layer of photovoltaic assemblies has a first row of photovoltaic assembly and a second row of photovoltaic assembly in a horizontal direction;
the first row of photovoltaic assembly and the second row of photovoltaic assembly can be relatively close to each other, to make the second layer of photovoltaic assemblies located at the first relative position with respect to the first layer of photovoltaic assemblies; and the first row of photovoltaic assembly and the second row of photovoltaic assembly can be relatively far away from each other, to make the second layer of photovoltaic assemblies located in the second relative position with respect to the first layer of photovoltaic assemblies.

In the above-mentioned photovoltaic container, optionally, a linear slide rail is disposed on the support frame, the support frame is connected to each row of photovoltaic assembly in the second layer of photovoltaic assemblies through the linear slide rail, to guide the each row of photovoltaic assembly in the second layer of photovoltaic assemblies;
wherein, the each row of photovoltaic assembly in the second layer of photovoltaic assemblies is connected to the support frame through a lead screw nut structure, to be driven through the lead screw nut structure so as to make the second layer of photovoltaic assemblies located at the first relative position and the second relative position with respect to the first layer of photovoltaic assemblies.

In the above-mentioned photovoltaic container, optionally, the each row of photovoltaic assembly in the second layer of photovoltaic assemblies includes at least one photovoltaic assembly unit;
the photovoltaic assembly unit includes a keel and the photovoltaic assembly mounted on the keel;
the keel is connected to a screw nut platform of the lead screw nut structure and a slide block of the linear slide rail respectively.

In the above-mentioned photovoltaic container, optionally, there are at least two layers of support frames in the vertical direction;
two adjacent layers of the support frames are spaced in the vertical direction, and each layer of photovoltaic assemblies is disposed on a different layer of the support frame from one another in one-to-one correspondence.

In the above-mentioned photovoltaic container, optionally, each layer of the support frame includes a frame structure constructed by connecting a plurality of connecting rods on the same plane;
wherein, two adjacent layers of frame structures are fixedly connected.

The beneficial effects of the photovoltaic container of the present disclosure are provided as follows.

In the technical solution provided by the present disclosure, the photovoltaic container is mounted on the container body framework of the container through the support frame, wherein the container body framework has higher strength and thus can provide strong support to the photovoltaic assembly. Compared to the existing photovoltaic assembly which is mounted on the top of the container and causes deformation of the housing at the top of the container, the container body framework and housing of the photovoltaic container of the present disclosure do not deform, therefore the photovoltaic assembly of the present disclosure has a longer service life.

The above illustration is only a summary of the technical solution of the present disclosure. In order to clarify and implement the technical solution of the present disclosure according to the description, preferred embodiments of the present invention will be detailed below in conjunction with the accompanying drawings.

### BRIEF DESCRIPTION OF DRAWINGS

FIG. 1 is a front view of a photovoltaic container according to an embodiment of the present invention;
FIG. 2 is a front view of a second layer of photovoltaic assemblies on a support frame when it is located at a first relative position with respect to a first layer of photovoltaic assemblies according to an embodiment of the present invention;
FIG. 3 is a front view of a second layer of photovoltaic assemblies on a support frame when it is located at a second relative position with respect to a first layer of photovoltaic assemblies according to an embodiment of the present invention;
FIG. 4 is a top view of a second layer of photovoltaic assemblies on a support frame when it is located at a second relative position with respect to a first layer of photovoltaic assemblies according to an embodiment of the present invention;
FIG. 5 is a top view of a photovoltaic assembly unit according to an embodiment of the present invention;
FIG. 6 is a structural schematic view of a support frame according to an embodiment of the present invention.

### DETAILED DESCRIPTION OF DISCLOSED EMBODIMENTS

In order to make the objectives, the technical schemes and the benefits of the present disclosure more apparent, the present disclosure will be described in more details through the following embodiments, structures, features and advantages in conjunction with the accompanying drawings. In the following description, various "an embodiment" or "embodiment" does not have to refer to the same embodiment. In addition, specific features, structures or characteristics in one or more embodiments can be combined in any appropriate form.

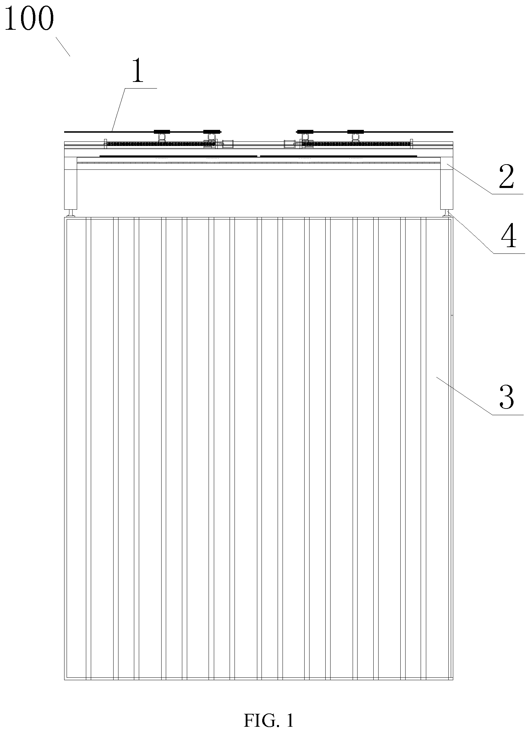

As shown in FIG.1, according to an embodiment of the present invention, a photovoltaic container 100 includes a photovoltaic assembly 1, a support frame 2 and a container body 3. The container body 3 includes a container body framework. The photovoltaic assembly 1 is mounted on the container body framework through the support frame 2, and is located outside the container body 3, so as to make the photovoltaic assembly 1 supported by the container body framework.

It should be noted that, the above-mentioned container body 3 further includes a container body housing mounted on the container body framework. Wherein, the container body framework has a higher strength and thus can provide support to the container body housing, so as to ensure the structural strength of the whole container body 3 and facilitate the installation of the container body housing.

The above-mentioned container body housing may adopt metal material and so on.

In the above-mentioned technical solution, because the photovoltaic assembly 1 is mounted on the container body framework of the container through the support frame 2, wherein the container body framework has a higher strength and thus can provide strong support to the photovoltaic assembly 1, in contrast to the existing photovoltaic assembly which is mounted on the top of the container and causes deformation of the housing at the container top, the container body framework and housing of the photovoltaic container 100 provided by the present disclosure do not deform, and accordingly, the photovoltaic assembly 1 of the present disclosure has a longer service life.

It should be noted that, the number of the above-mentioned support frame 2 may be two or more, so as to reduce the size and weight of a single support frame 2 and facilitate the workers to mount the support frame 2 onto the container body framework of the container body 3.

Furthermore, as shown in FIG. 1, the above-mentioned photovoltaic assembly 1 is located above the top surface of the container body 3. The photovoltaic assembly 1 is mounted on the support frame 2, the support frame 2 is mounted on a first part of the container body framework, and the first part is located on the top of the container body 3. In this example, the photovoltaic assembly 1 and the support frame 2 are both located in the open space above the top surface of the container body 3, thus the installation thereof is not limited by the installation space and do not affect a user's walking along the side of the container body 3.

As shown in FIG. 1, the photovoltaic container 100 includes a horizontal adjustment footstand 4. The above-mentioned support frame 2 is mounted on the container body framework through the horizontal adjustment footstands 4, so as to adjust the horizontality of the photovoltaic assembly 1 on the support frame 2 by the horizontal adjustment footstands 4. In this example, it is possible to adjust the angle of the photovoltaic assemble 1 by the disposed horizontal adjustment footstands 4 in order to better receive sunlight and improve the working efficiency of the photovoltaic assembly 1.

It should be noted that, the above-mentioned horizontal adjustment footstand 4 is a commercially available component, which can be bought in the market, the details will not be repeated here.

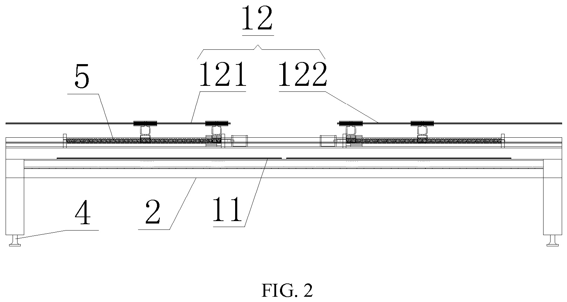

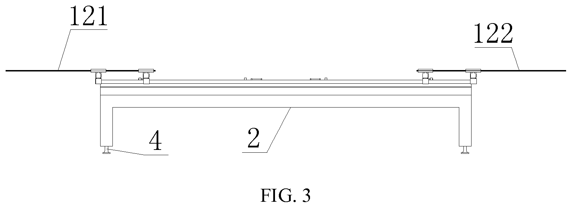

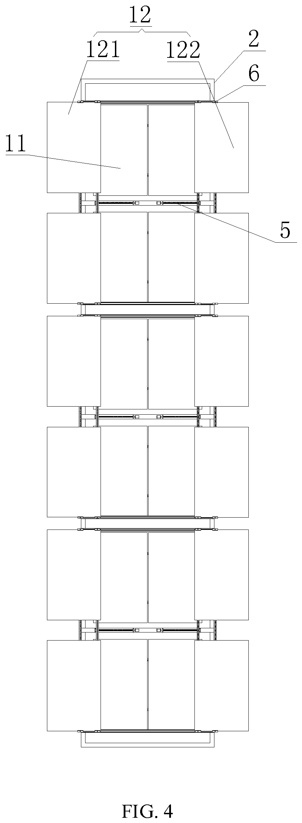

Furthermore, as shown in FIG. 2 to FIG. 4, the photovoltaic container 100 of the present disclosure has at least two layers of photovoltaic assemblies in the vertical direction. Wherein each of the layers of photovoltaic assemblies can be moveable relative to one another, for example, can be moved to a first relative position at which the layers of photovoltaic assemblies overlap each other in the vertical direction (as shown in FIG. 2) and to a second relative position at which the layers of photovoltaic assemblies are spread out relatively (as shown in FIG. 3 and FIG. 4). In this example, by disposing a plurality of layers of photovoltaic assemblies, the number of the photovoltaic assembly 1 can be increased, thereby improving the photovoltaic capacity of the photovoltaic container 100 of the present disclosure.

It should be noted that, when two adjacent layers of photovoltaic assemblies overlap each other in the vertical direction, the two adjacent layers of photovoltaic assemblies may be spaced in the vertical direction or may be contacted with each other. In order to prevent interference between the two adjacent layers of photovoltaic assemblies, preferably, when the two adjacent layers of photovoltaic assemblies overlap each other in the vertical direction, the two adjacent layers of photovoltaic assemblies are spaced in the vertical direction.

The position of the above-mentioned photovoltaic assembly can be switched between the first relative position and the second relative position by rectilinear translation, thereby achieving a technical effect of easy operation.

When implemented, as shown in FIG. 2, the above-mentioned layers of photovoltaic assemblies include a first layer of photovoltaic assemblies 11 and a second layer of photovoltaic assemblies 12 which are adjacently disposed. The first layer of photovoltaic assemblies 11 is fixed on the support frame 2. The second layer of photovoltaic assemblies 12 is movably disposed on the support frame 2, to be moved to the above-mentioned first relative position and second relative position with respect to the first layer of photovoltaic assemblies 11. It is possible that both of the first layer of photovoltaic assemblies 11 and the second layer of photovoltaic assemblies 12 are relatively moveable, but in this example, by fixing the first layer of photovoltaic assemblies 11 and only making the second layer of photovoltaic assemblies movable, the structure of movement mechanism can be simplified and the cost can be saved.

Furthermore, as shown in FIG. 2 to FIG. 4, the above-mentioned second layer of photovoltaic assemblies 12 includes a first row of photovoltaic assembly 121 and a second row of photovoltaic assembly 122 in the horizontal direction. The first row of photovoltaic assembly 121 and the second row of photovoltaic assembly 122 can be relatively close to each other, to make the second layer of photovoltaic assemblies located at the above-mentioned first relative position (as shown in FIG. 2) with respect to the first layer of photovoltaic assemblies; and the first row of photovoltaic assembly 121 and the second row of photovoltaic assembly 122 can be relatively far away from each other, to make the second layer of photovoltaic assemblies 12 located at the above-mentioned second relative position (as shown in FIG. 3 and FIG. 4) with respect to the first layer of photovoltaic assemblies 11. In this example, by disposing two rows of photovoltaic assemblies in the second layer, the number of photovoltaic assembly 1 can be further increased, thereby improving the photovoltaic capacity of the photovoltaic container 100 of the present disclosure.

It should be noted that, as shown in FIG. 4, when the second layer of photovoltaic assemblies 12 is located at the second relative position with respect to the first layer of photovoltaic assemblies 11, the projection of the above-mentioned first row of photovoltaic assembly 121 on the plane of the first layer of photovoltaic assemblies 11 is located at a first side of the first layer of photovoltaic assemblies 11, while the projection of the second row of photovoltaic assembly 122 on the plane of the first layer of photovoltaic assemblies 11 is located at a second side of the first layer of photovoltaic assemblies 11, wherein, the first side is opposite to the second side. By the settings in this example, the arrangement of each photovoltaic assembly 1 becomes more reasonable, each photovoltaic assembly 1 may not be interfered or shaded by one another, thus each photovoltaic assembly 1 can be fully exposed to the sunlight and the working efficiency of each photovoltaic assembly 1 can be maximized.

Furthermore, as shown in FIG. 2 to FIG. 4, a guide structure, disposed on the above-mentioned support frame 2, is configured to guide each row of photovoltaic assembly 1 in the second layer of photovoltaic assemblies 12. Wherein, each row of photovoltaic assembly in the second layer of photovoltaic assemblies 12 is connected to the support frame 2 through a lead screw nut structure 5, and is driven by the lead screw nut structure 5 such that the second layer of photovoltaic assemblies 12 is located at the above-mentioned first relative position and second relative position with respect to the first layer of photovoltaic assemblies 11. In this example, the cooperation of the guide structure and the lead screw nut structure can effectively ensure the motion stability of each row of photovoltaic assembly in the second layer of photovoltaic assemblies 12, thereby realizing the smooth stretching and contracting movements of each row of photovoltaic assembly in the second layer of photovoltaic assemblies 12.

It should be noted that, the lead screw of the above-mentioned lead screw nut structure 5 may be a ball screw so as to reduce the motion resistance.

The above-mentioned guide structure may include a linear slide rail 6. The support frame 2 is connected to each row of photovoltaic assembly in the second layer of photovoltaic assemblies 12 through the liner slide rail 6, to guide each row of photovoltaic assembly in the second layer of photovoltaic assemblies 12.

It should be noted that, there may be a plurality of the above-mentioned lead screw nut structures 5 and the linear slide rails 6, so as to further guide and drive each row of photovoltaic assembly in the second layer of photovoltaic assemblies 12, thereby realizing the smooth stretching and contracting movements of each row of photovoltaic assembly in the second layer of photovoltaic assemblies 12.

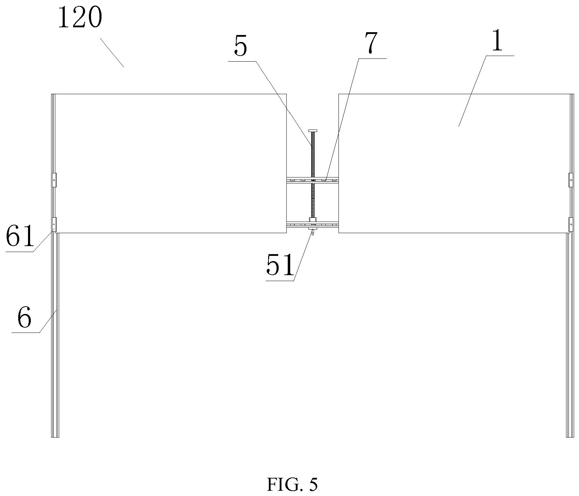

According to a specific embodiment of the present invention, as shown in FIG. 5, each row of photovoltaic assembly in the above mentioned second layer of photovoltaic assemblies 12 can include at least one photovoltaic assembly unit 120, and the assembly unit 120 includes a keel 7 and the photovoltaic assembly 1 mounted on the keel 7. The keel 7 is connected to a screw nut platform 51 of the lead screw nut structure 5 and a slide block 61 of the linear slide rail 6 respectively.

Furthermore, there may be two photovoltaic assemblies 1 in each of the above-mentioned photovoltaic assembly unit 120. Each photovoltaic assembly unit 120 is guided by two linear slide rails 6, and is connected to the support frame 2 by one lead screw nut structure 5.

Furthermore, there are at least two layers of the above-mentioned support frames 2 in the vertical direction, and the two adjacent layers of the support frames 2 are spaced in the vertical direction. Each layer of the above-mentioned photovoltaic assemblies is laid on a different layer of the support frame 2 from one another in one-to-one correspondence. Because the two adjacent layers of the support frames 2 are spaced in the vertical direction, the arrangement facilitates the installation of the above-mentioned each layer of photovoltaic assemblies 1 and prevents interference between the two adjacent layers of photovoltaic assemblies 1.

Each layer of the above-mentioned support frame 2 may include a frame structure constructed by connecting a plurality of connecting rods on the same plane. Wherein, the two adjacent layers of frame structures are fixedly connected. In this example, the frame structure constructed by connecting a plurality of connecting rods on the same plane may facilitate the installation of the photovoltaic assembly 1 and effectively ensure the horizontality of the mounted photovoltaic assembly 1, so as to make the photovoltaic assembly 1 capable of receiving solar energy with the maximum efficiency.

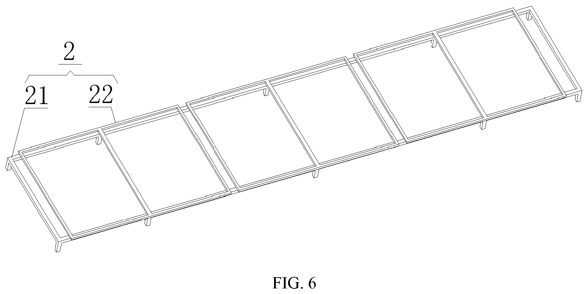

According to a specific embodiment of the present invention, as shown in FIG. 6, there are two layers of the support frames 2 in the vertical direction, the first layer 21 and the second layer 22 respectively. Wherein, each of the first layer 21 and the second layer 22 may include a frame structure constructed by connecting a plurality of connecting rods on the same plane. The frame structure of the first layer 21 and the frame structure of the second layer 22 are fixedly connected.

The operating principle of the present disclosure and preferred embodiments of the present invention are described below.

The technical solution provided by the present disclosure solves the following technical problems: (1) since the existing photovoltaic assembly is directly laid on the top surface of the container, the pressure of the weight of the photovoltaic assembly may easily cause depression and deformation of the iron sheet in the top layer of the container, which reduces the service life of the container; (2) as the existing container has an uneven top surface, it is difficult to satisfy the technical requirements of laying the photovoltaic assembly; (3) since the area of the top surface of the existing container is very limited, the photovoltaic capacity is insufficient when directly laying the photovoltaic assembly on the top surface of the container.

According to the technical solution provided by the present disclosure, as the photovoltaic assembly 1 is mounted on the container body frameworks on four sides of the container via the support frame 2, the container body housing such as iron sheet at the container top is prevented from depressing and deforming due to overloading, thereby prolonging the service life of the container. The photovoltaic assembly 1 is mounted on the support frame 2, and the support frame 2 is mounted on the container body framework on the top of the container through the horizontal adjustment footstands 4. Wherein, the horizontal adjustment footstand 4 can adjust the horizontality of the photovoltaic assembly 1 on the support frame 2 so as to satisfy the technical requirements of laying the photovoltaic assembly 1.

Specifically, when mounting the photovoltaic assembly 1, the photovoltaic assembly 1 can be first mounted on the support frame 2 on the ground, and then the support frame 2 mounted with the photovoltaic assembly 1 is hoisted and mounted onto the top of the container. Such an operation is very easy and has a high safety.

Wherein, a double-laying manner can be adopted in mounting the photovoltaic assembly 1 on the support frame 2, so as to increase the number of laid photovoltaic assembly 1 and improve the photovoltaic capacity of the container. Wherein, the lower layer of photovoltaic assemblies, i.e., the above-mentioned first layer of photovoltaic assemblies 11, is directly fixed on the support frame 2; and the upper layer of photovoltaic assemblies, i.e., the above-mentioned second layer of photovoltaic assemblies 12, is mounted on the support frame 2 through the ball screw nut structure 5, to realize the stretching and contracting movements on the support frame 2 through the ball screw nut structure 5.

Wherein, the above-mentioned lower layer of photovoltaic assemblies is directly fixed on the support frame 2 by means of pressing block connection. The upper layer of photovoltaic assemblies is divided into six separate units, and the photovoltaic assembly 1 of each unit is fixedly mounted on the keel 7 through the pressing block connection. The keel 7 is connected to the above-mentioned screw nut platform 51 of the lead screw nut structure 5, and the lead screw of the lead screw nut structure 5 is mounted on the support frame 2. Wherein, the ball screw can drive the screw nut platform 51 to move to realize the stretching and contacting movements of the upper layer of photovoltaic assemblies on the support frame 2.

The linear slide rail 6 is further mounted on the support frame 2, and the slide block 61 of the linear slide rail 6 is connected to the keel 7 of the upper layer of photovoltaic assemblies. By moving the slide block 61 on the slide rail, smooth stretching and contacting movements of the upper layer of photovoltaic assemblies on the support frame 2 are realized.

The above-mentioned support frame system of photovoltaic assembly can be divided into two or more parts to assemble, and then to fit with the container. More layers of stretching and contacting device for the photovoltaic assemblies may be designed on the above-mentioned support frame 2.

## Claims

1. A photovoltaic container comprising a photovoltaic assembly (1), a support frame (2) and a container body (3);
wherein the container body (3) comprises a container body framework and a container body housing mounted on the container body framework, the container body framework having a higher strength than the container body housing;
wherein the photovoltaic assembly (1) is mounted on the container body framework through the support frame (2) and located outside the container body (3), to make the photovoltaic assembly (1) supported by the container body framework; **characterized in that** the photovoltaic container comprises a horizontal adjustment footstand (4), wherein the support frame (2) is mounted on the container body framework through the horizontal adjustment footstand (4), to adjust horizontality of the photovoltaic assembly (1) on the support frame (2) by the horizontal adjustment footstand (4).

2. The photovoltaic container of claim 1, **characterized in that**,
the photovoltaic assembly (1) is located above a top surface of the container body (3);
the photovoltaic assembly (1) is mounted on the support fame (2), the support fame (2) is mounted on a first part of the container body framework, the first part is located on a top of the container body (3).

3. The photovoltaic container of claim 1 or 2, **characterized in that**,
the photovoltaic container has at least two layers of photovoltaic assemblies in a vertical direction;
wherein, each of layers of photovoltaic assemblies is moveable relative to one another, to move to a first relative position at which the at least two layers of photovoltaic assemblies overlap each other in the vertical direction and a second relative position at which the at least two layers of photovoltaic assemblies are spread out relatively.

4. The photovoltaic container of claim 3, **characterized in that**,
the layers of photovoltaic assemblies have a first layer of photovoltaic assemblies (11) and a second layer of photovoltaic assemblies (12) which are adjacently disposed;
the first layer of photovoltaic assemblies (11) is fixed on the support frame (2);
the second layer of photovoltaic assemblies (12) is movably disposed on the support frame (2), to move to the first relative position and the second relative position with respect to the first layer of photovoltaic assemblies (11).

5. The photovoltaic container of claim 4, **characterized in that**,
the second layer of photovoltaic assemblies (12) has a first row of photovoltaic assembly (121) and a second row of photovoltaic assembly (122) in a horizontal direction;
the first row of photovoltaic assembly (121) and the second row of photovoltaic assembly (122) can be relatively close to each other, to make the second layer of photovoltaic assemblies (12) located at the first relative position with respect to the first layer of photovoltaic assemblies (11); and the first row of photovoltaic assembly (121) and the second row of photovoltaic assembly (122) can be relatively far away from each other, to make the second layer of photovoltaic assemblies (12) located at the second relative position with respect to the first layer of photovoltaic assemblies (11).

6. The photovoltaic container of claim 5, **characterized in that**,
a linear slide rail (6) is disposed on the support frame (2), the support frame (2) is connected to each row of photovoltaic assembly in the second layer of photovoltaic assemblies (12) through the linear slide rail (6), to guide the each row of photovoltaic assembly in the second layer of photovoltaic assemblies (12);
wherein, the each row of photovoltaic assembly in the second layer of photovoltaic assemblies (12) is connected to the support frame (2) through a lead screw nut structure (5), to be driven by the lead screw nut structure (5) so as to make the second layer of photovoltaic assemblies (12) located at the first relative position and the second relative position with respect to the first layer of photovoltaic assemblies (11).

7. The photovoltaic container of claim 6, **characterized in that**,
the each row of photovoltaic assembly in the second layer of photovoltaic assemblies (12) comprises at least one photovoltaic assembly unit (120);
the photovoltaic assembly unit (120) comprises a keel (7) and the photovoltaic assembly (1) mounted on the keel (7);
the keel (7) is connected to a screw nut platform (51) of the lead screw nut structure (5) and a slide block (61) of the linear slide rail (6) respectively.

8. The photovoltaic container of any one of claims 3 to 7, **characterized in that**, there are at least two layers of support frames (2) in the vertical direction;
two adjacent layers of the support frames (2) are spaced in the vertical direction, and each layer of photovoltaic assemblies is disposed on a different layer of the support frame (2) from one another in one-to-one correspondence.

9. The photovoltaic container of claim 8, **characterized in that**,
each layer of the support frame (2) comprises a frame structure constructed by connecting a plurality of connecting rods on the same plane;
wherein, two adjacent layers of frame structures are fixedly connected.

## Patentansprüche

1. Fotovoltaikbehälter, der eine Fotovoltaikanordnung (1), einen Tragrahmen (2) und einen Behälterkörper (3) umfasst;
wobei der Behälterkörper (3) einen Behälterkörperrahmen und ein auf dem Behälterkörperrahmen montiertes Behälterkörpergehäuse umfasst, wobei der Behälterkörperrahmen eine höhere Festigkeit als das Behälterkörpergehäuse aufweist;
wobei die Fotovoltaikanordnung (1) durch den Tragrahmen (2) am Behälterkörperrahmen montiert und außerhalb des Behälterkörpers (3) angeordnet ist, um die Fotovoltaikanordnung (1) durch den Behälterkörperahmen zu tragen; **dadurch gekennzeichnet, dass** der Fotovoltaikbehälter einen horizontalen Einstellfuß (4) umfasst, wobei
der Tragrahmen (2) durch den horizontalen Einstellfuß (4) auf dem Behälterkörperahmen montiert ist, um die Horizontalität der Fotovoltaikanordnung (1) auf dem Tragrahmen (2) durch den horizontalen Einstellfuß (4) einzustellen.

2. Fotovoltaikbehälter nach Anspruch 1, **dadurch gekennzeichnet, dass**
die Fotovoltaikanordnung (1) oberhalb einer oberen Oberfläche des Behälterkörpers (3) angeordnet ist;
die Fotovoltaikanordnung (1) auf dem Tragrahmen (2) montiert ist, der Tragrahmen (2) auf einem ersten Teil des Behälterkörperrahmens montiert ist, wobei der erste Teil auf einer Oberseite des Behälterkörpers (3) angeordnet ist.

3. Fotovoltaikbehälter nach Anspruch 1 oder 2, **dadurch gekennzeichnet, dass**
der Fotovoltaikbehälter mindestens zwei Schichten von Fotovoltaikanordnungen in vertikaler Richtung aufweist;
wobei jede der Schichten von Fotovoltaikanordnungen relativ zueinander beweglich ist, um sich in eine erste relative Position zu bewegen, in der die mindestens zwei Schichten von Fotovoltaikanordnungen einander in der vertikalen Richtung überlappen, und in eine zweite relative Position, in der die mindestens zwei Schichten von Fotovoltaikanordnungen relativ zueinander ausgebreitet sind.

4. Fotovoltaikbehälter nach Anspruch 3, **dadurch gekennzeichnet, dass**
die Schichten von Fotovoltaikanordnungen eine erste Schicht von Fotovoltaikanordnungen (11) und eine zweite Schicht von Fotovoltaikanordnungen (12) aufweisen, die nebeneinander angeordnet sind;
die erste Schicht von Fotovoltaikanordnungen (11) auf dem Tragrahmen (2) befestigt ist;
die zweite Schicht von Fotovoltaikanordnungen (12) beweglich auf dem Tragrahmen (2) angeordnet ist, um sich in die erste relative Position und die zweite relative Position in Bezug auf die erste Schicht von Fotovoltaikanordnungen (11) zu bewegen.

5. Fotovoltaikbehälter nach Anspruch 4, **dadurch gekennzeichnet, dass**
die zweite Schicht von Fotovoltaikanordnungen (12) eine erste Reihe von Fotovoltaikanordnung (121) und eine zweite Reihe von Fotovoltaikanordnung (122) in einer horizontalen Richtung aufweist;
die erste Reihe der Fotovoltaikanordnung (121) und die zweite Reihe der Fotovoltaikanordnung (122) relativ nahe beieinander sein können, um die zweite Schicht der Fotovoltaikanordnungen (12) in der ersten relativen Position in Bezug auf die erste Schicht der Fotovoltaikanordnungen (11) anzuordnen; und die erste Reihe der Fotovoltaikanordnung (121) und die zweite Reihe der Fotovoltaikanordnung (122) relativ weit voneinander entfernt sein können, um die zweite Schicht der Fotovoltaikanordnungen (12) in der zweiten relativen Position in Bezug auf die erste Schicht der Fotovoltaikanordnungen (11) anzuordnen.

6. Fotovoltaikbehälter nach Anspruch 5, **dadurch gekennzeichnet, dass**
eine lineare Gleitschiene (6) auf dem Tragrahmen (2) angeordnet ist, wobei der Tragrahmen (2) mit jeder Reihe von Fotovoltaikanordnung in der zweiten Schicht von Fotovoltaikanordnungen (12) durch die lineare Gleitschiene (6) verbunden ist, um jede Reihe von Fotovoltaikanordnung in der zweiten Schicht von Fotovoltaikanordnungen (12) zu führen;
wobei jede Reihe von Fotovoltaikanordnung in der zweiten Schicht von Fotovoltaikanordnungen (12) mit dem Tragrahmen (2) durch eine Leitspindelmutterstruktur (5) verbunden ist, um durch die Leitspindelmutterstruktur (5) angetrieben zu werden, so dass die zweite Schicht von Fotovoltaikanordnungen (12) in der ersten relativen Position und der zweiten relativen Position in Bezug auf die erste Schicht von Fotovoltaikanordnungen (11) angeordnet ist.

7. Fotovoltaikbehälter nach Anspruch 6, **dadurch gekennzeichnet, dass**
jede Reihe von Fotovoltaikanordnung in der zweiten Schicht von Fotovoltaikanordnungen (12) mindestens eine Fotovoltaikanordnungseinheit (120) umfasst;
die Fotovoltaikanordnungseinheit (120) einen Stabilisierer (7) und die auf dem Stabilisierer (7) montierte Fotovoltaikanordnung (1) umfasst;
der Stabilisierer (7) mit einer Spindelmutterplattform (51) der Leitspindelmutterstruktur (5) bzw. einem Gleitblock (61) der linearen Gleitschiene (6) verbunden ist.

8. Fotovoltaikbehälter nach einem der Ansprüche 3 bis 7, **dadurch gekennzeichnet, dass**
mindestens zwei Schichten von Tragrahmen (2) in vertikaler Richtung vorhanden sind;
zwei benachbarte Schichten der Tragrahmen (2) in vertikaler Richtung voneinander beabstandet sind und jede Schicht der Fotovoltaikanordnungen auf einer anderen Schicht des Tragrahmens (2) voneinander in eins-zu-eins-Entsprechung angeordnet ist.

9. Fotovoltaikbehälter nach Anspruch 8, **dadurch gekennzeichnet, dass**
jede Schicht des Tragrahmens (2) eine Rahmenstruktur umfasst, die durch Verbinden einer Vielzahl von Verbindungsstäben in derselben Ebene aufgebaut ist;
wobei zwei benachbarte Schichten von Rahmenstrukturen fest verbunden sind.

## Revendications

1. Récipient photovoltaïque comprenant un ensemble photovoltaïque (1), un bâti de support (2) et un corps de récipient (3),
dans lequel le corps de récipient (3) comprend un cadre de corps de récipient et un boîtier de corps de récipient monté sur le cadre de corps de récipient, le cadre de corps de récipient ayant une plus grande résistance que le boîtier de corps de récipient ;
dans lequel l'ensemble photovoltaïque (1) est monté sur le cadre de corps de récipient par le biais du bâti de support (2) et positionné à l'extérieur du corps de récipient (3), pour que l'ensemble photovoltaïque (1) soit supporté par le cadre de corps de récipient, **caractérisé en ce que** le récipient photovoltaïque comprend un pied d'ajustement horizontal (4), dans lequel le bâti de support (2) est monté sur le cadre de corps de récipient par le biais du pied d'ajustement horizontal (4) pour ajuster l'horizontalité de l'ensemble photovoltaïque (1) sur le boîtier de support (2) grâce au pied d'ajustement horizontal (4).

2. Récipient photovoltaïque selon la revendication 1, **caractérisé en ce que** :
l'ensemble photovoltaïque (1) est positionné au-dessus d'une surface supérieure du corps de récipient (3) ;
l'ensemble photovoltaïque (1) est monté sur le bâti de support (2), le bâti de support (2) est monté sur une première partie du cadre de corps de récipient, la première partie est positionnée sur une partie supérieure du corps de récipient (3).

3. Récipient photovoltaïque selon la revendication 1 ou 2, **caractérisé en ce que** :
le récipient photovoltaïque a au moins deux couches d'ensembles photovoltaïques dans une direction verticale ;
dans lequel chacune des couches d'ensembles photovoltaïques est mobile par rapport à l'autre, pour se déplacer dans une première position relative dans laquelle les au moins deux couches d'ensembles photovoltaïques se chevauchent dans la direction verticale et une seconde position relative dans laquelle les au moins deux couches d'ensembles photovoltaïques sont relativement étalées.

4. Récipient photovoltaïque selon la revendication 3, **caractérisé en ce que** :
les couches d'ensembles photovoltaïques ont une première couche d'ensembles photovoltaïques (11) et une seconde couche d'ensembles photovoltaïques (12) qui sont disposées de manière adjacente ;
la première couche d'ensembles photovoltaïques (11) est fixée sur le bâti de support (2) ;
la seconde couche d'ensembles photovoltaïques (12) est disposée de manière mobile sur le bâti de support (2), pour se déplacer dans la première position relative et la seconde position relative par rapport à la première couche d'ensembles photovoltaïques (11).

5. Récipient photovoltaïque selon la revendication 4, **caractérisé en ce que** :
la seconde couche d'ensembles photovoltaïques (12) a une première rangée d'ensemble photovoltaïque (121) et une seconde rangée d'ensemble photovoltaïque (122) dans une direction horizontale ;
la première rangée d'ensemble photovoltaïque (121) et la seconde rangée d'ensemble photovoltaïque (122) peuvent être relativement proches l'une de l'autre, pour que la seconde couche d'ensembles photovoltaïques (12) soit positionnée dans la première position relative par rapport à la première couche d'ensembles photovoltaïques (11) ; et la première rangée d'ensemble photovoltaïque (121) et la seconde rangée d'ensemble photovoltaïque (122) peuvent être relativement éloignées l'une de l'autre, pour que la seconde couche d'ensembles photovoltaïques (12) soit positionnée dans la seconde position relative par rapport à la première couche d'ensembles photovoltaïques (11).

6. Récipient photovoltaïque selon la revendication 5, **caractérisé en ce que** :
un rail de coulissement linéaire (6) est disposé sur le bâti de support (2), le bâti de support (2) est raccordé à chaque rangée d'ensemble photovoltaïque dans la seconde couche d'ensembles photovoltaïques (12) par le biais du rail de coulissement linéaire (6), pour guider chaque rangée d'ensemble photovoltaïque dans la seconde couche d'ensembles photovoltaïques (12) ;
dans lequel chaque rangée d'ensemble photovoltaïque dans la seconde couche d'ensembles photovoltaïques (12) est raccordée au bâti de support (2) par le biais d'une structure d'écrou de vis-mère (5), pour être entraînée par la structure d'écrou de vis-mère (5) pour que la seconde couche d'ensembles photovoltaïques (12) soit positionnée dans la première position relative et la seconde position relative par rapport à la première couche d'ensembles photovoltaïques (11).

7. Récipient photovoltaïque selon la revendication 6, **caractérisé en ce que** :
chaque rangée d'ensemble photovoltaïque dans la seconde couche d'ensembles photovoltaïques (12) comprend au moins une unité d'ensemble photovoltaïque (120) ;
l'unité d'ensemble photovoltaïque (120) comprend une quille (7) et l'ensemble photovoltaïque (1) monté sur la quille (7) ;
la quille (7) est respectivement raccordée à une plateforme d'écrou de vis (51) de la structure d'écrou de vis-mère (5) et à un bloc de coulissement (61) du rail de coulissement linéaire (6).

8. Récipient photovoltaïque selon l'une quelconque des revendications 3 à 7, **caractérisé en ce que** :
il y a au moins deux couches de bâtis de support (2) dans la direction verticale ;
deux couches adjacentes de bâtis de support (2) sont espacées dans la direction verticale ; et chaque couche d'ensembles photovoltaïques est disposée sur une couche différente du bâti de support (2) en correspondance une à une.

9. Récipient photovoltaïque selon la revendication 8, **caractérisé en ce que** :
chaque couche du bâti de support (2) comprend une structure de bâti construite en raccordant une pluralité de tiges de raccordement sur le même plan ;
dans lequel deux couches adjacentes des structures de bâti sont raccordées de manière fixe.
